(19) Europäisches Patentamt
European Patent Office
Office européen des brevets

(11) **EP 4 682 559 A1**

(12) **EUROPEAN PATENT APPLICATION**
published in accordance with Art. 153(4) EPC

(43) Date of publication:
**21.01.2026 Bulletin 2026/04**

(21) Application number: **23927569.6**

(22) Date of filing: **24.10.2023**

(51) International Patent Classification (IPC):
*G01R 31/387* (2019.01)   *G01R 31/382* (2019.01)
*G01R 31/385* (2019.01)   *G01R 31/392* (2019.01)
*H01M 10/48* (2006.01)   *H02J 7/00* (2026.01)
*H02J 7/02* (2016.01)

(52) Cooperative Patent Classification (CPC):
**G01R 31/382; G01R 31/385; G01R 31/387;
G01R 31/392; H01M 10/48; H02J 7/00; H02J 7/02**

(86) International application number:
**PCT/JP2023/038246**

(87) International publication number:
**WO 2024/189954 (19.09.2024 Gazette 2024/38)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **14.03.2023 JP 2023039533**

(71) Applicant: HITACHI HIGH-TECH CORPORATION
Tokyo 105-6409 (JP)

(72) Inventors:
• **MOCHIZUKI Masahito**
**Tokyo 105-6409 (JP)**
• **YONEMOTO Masahiro**
**Tokyo 105-6409 (JP)**
• **SUMIKAWA Yosuke**
**Tokyo 105-6409 (JP)**
• **HORIKOSHI Nobuya**
**Tokyo 105-6409 (JP)**

(74) Representative: **MERH-IP Matias Erny Reichl
Hoffmann
Patentanwälte PartG mbB
Paul-Heyse-Straße 29
80336 München (DE)**

(54) **SECONDARY BATTERY STATE DIAGNOSIS SYSTEM AND STATE DIAGNOSIS METHOD**

(57)    Provided are a secondary battery state diagnosis system and a secondary battery state diagnosis method that are capable of estimating a full charge capacity more accurately even when there is a period in which data is not acquired with respect to a secondary battery of an electric vehicle. A calculation unit of the secondary battery state diagnosis system a) calculates a first SOC based on a first voltage at a first time point when voltage application related to charging starts, b) calculates, when the voltage application related to the charging ends at a second time point, a relaxation time based on a second voltage at the second time point and the temperature, c) calculates a second SOC based on a third voltage at a third time point after the second time point, and d) estimates, when a time from the second time point to the third time point is equal to or longer than the relaxation time, the full charge capacity of the battery cell or the battery pack based on a current related to the charging, the first SOC, and the second SOC.

FIG. 3

# EP 4 682 559 A1

**Description**

Technical Field

The present invention relates to a secondary battery state diagnosis system and a secondary battery state diagnosis method.

Background Art

When external charging is performed on a secondary battery of an electric vehicle, it is important to calculate a state of charge (SOC) and a full charge capacity. These values can be calculated based on a temperature of the battery, a voltage and a current related to the charging, and the like. An example of such a technique is described in PTL 1.
When a voltage of the battery during the charging or immediately after the charging is measured, it is important to evaluate a polarization voltage. An example of a formula for calculating the polarization voltage is described in paragraph [0050] in PTL 2.

Citation List

Patent Literature

    PTL 1: JP2015-202010A
    PTL 2: JP2017-107763A

Summary of Invention

Technical Problem

However, there is a period in which data on the battery is not acquired in the electric vehicle or the like, and therefore, the related art has a problem that it may be difficult to accurately estimate a full charge capacity.
Measurement data on a secondary battery mounted on an electric vehicle is acquired by a telematics device via a battery management system (BMS). In such a configuration, since the telematics device stops acquiring data at a time point when a power supply of the electric vehicle is turned off, there is a time period in which the data is not measured.
Due to this time period, there is a case where an OCV after polarization of the battery is reduced cannot be acquired, and it is difficult to accurately calculate the SOC and to accurately estimate the full charge capacity.
The invention has been made to solve such a problem, and an object of the invention is to provide a secondary battery state diagnosis system and a secondary battery state diagnosis method that are capable of estimating a full charge capacity more accurately even when there is a period in which data on the battery is not acquired.

Solution to Problem

In an example of a secondary battery state diagnosis system according to the invention, the secondary battery state diagnosis system includes a data acquisition unit and a calculation unit. The data acquisition unit acquires a current, a voltage, and a temperature related to a battery cell or a battery pack obtained by combining a plurality of battery cells. The calculation unit a) calculates a first SOC using a SOC-OCV relationship table based on a first voltage at a first time point when voltage application related to charging starts in a case where external charging is performed on the battery cell or the battery pack, in which the SOC-OCV relationship table is a table for indicating a relationship between the voltage and the SOC, b) calculates, when the voltage application related to the charging ends at a second time point, a relaxation time of the battery cell or the battery pack based on a second voltage at the second time point and the temperature, c) calculates, when the data acquisition unit acquires a third voltage at a third time point after the second time point, a second SOC using the SOC-OCV relationship table based on the third voltage, and d) estimates, when a time from the second time point to the third time point is equal to or longer than the relaxation time, a full charge capacity of the battery cell or the battery pack based on the current related to the charging, the first SOC, and the second SOC.
The present specification includes contents disclosed in Japanese Patent Application No. 2023-039533 which are the basis of the priority of the present application.

Advantageous Effects of Invention

According to the secondary battery state diagnosis system and the secondary battery state diagnosis method of the invention, it is possible to estimate the full charge capacity more accurately even when there is a period in which data on the battery is not acquired.

Brief Description of Drawings

[FIG. 1] FIG. 1 shows a configuration example including a secondary battery state diagnosis system according to Embodiment 1 of the invention.
[FIG. 2] FIG. 2 shows an example of a SOC-OCV relationship table related to a battery in FIG. 1.
[FIG. 3] FIG. 3 is a diagram showing a change in a situation during charging and before and after the charging when external charging is performed on the battery in FIG. 1.
[FIG. 4] FIG. 4 is a flowchart showing a process executed by the secondary battery state diagnosis system according to Embodiment 1.
[FIG. 5] FIG. 5 is a flowchart showing a process executed by a secondary battery state diagnosis system according to Embodiment 2.

Description of Embodiments

Hereinafter, embodiments of the invention will be described with reference to the accompanying drawings.

[Embodiment 1]

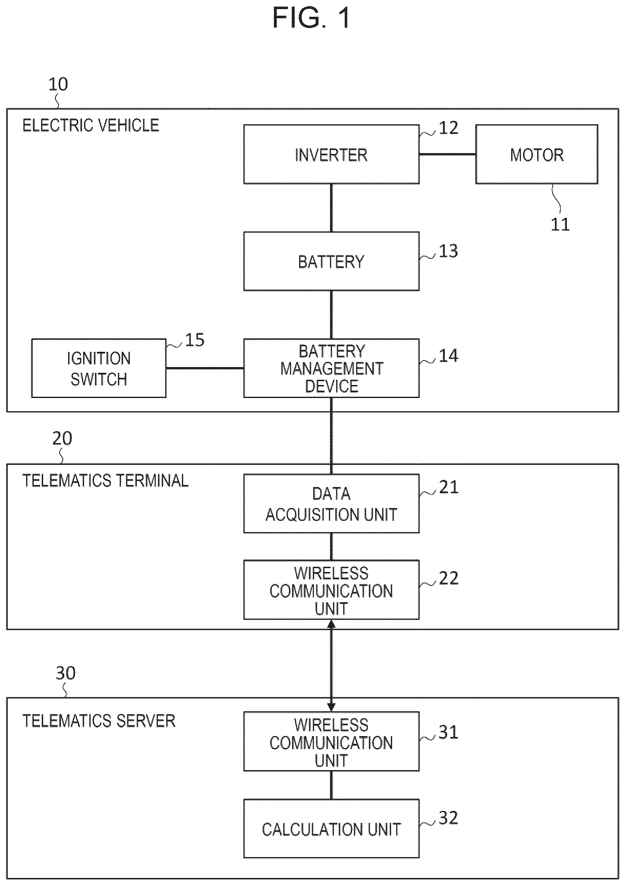

FIG. 1 shows a configuration example including a secondary battery state diagnosis system (hereinafter, may be simply referred to as a "battery diagnosis system") according to the present embodiment. The secondary battery state diagnosis system is provided in association with an electric vehicle 10 (which may be referred to as an EV).

The electric vehicle 10 includes the following components.

- A motor 11 that drives the electric vehicle 10.
- A battery 13 that supplies power to the motor 11. The battery 13 is a secondary battery and may be, for example, a single secondary battery cell or a battery pack obtained by combining a plurality of battery cells. Hereinafter, the secondary battery may be simply referred to as a "battery".
- An inverter 12 that converts the power supplied from the battery 13 and supplies the converted power to the motor 11.
- A battery management device 14 that controls and manages the battery 13.
- An ignition switch 15 used to perform operations related to a power supply of the electric vehicle 10 (particularly, the battery management device 14).

A telematics terminal 20 is mounted on the electric vehicle 10. The telematics terminal 20 acquires data in association with the electric vehicle 10. The telematics terminal 20 may function as a car navigation system, a drive recorder, or the like.

The telematics terminal 20 includes a data acquisition unit 21 and a wireless communication unit 22.

The data acquisition unit 21 is communicably connected to the battery management device 14 of the electric vehicle 10 in a wired or wireless manner, and can acquire data related to the battery 13. The data acquisition unit 21 particularly acquires a timestamp, a current related to the battery 13, a voltage related to the battery 13, and a temperature related to the battery 13 (or a temperature of a surrounding environment of the battery). The timestamp is a date and time when measurement data is acquired (or a date and time when measurement is performed). Therefore, a temperature sensor, a current sensor, a voltage sensor, and the like may be provided in association with the battery 13.

The wireless communication unit 22 can communicate with an external computer (for example, a telematics server 30 to be described later) in the wireless manner.

The telematics server 30 is disposed outside (for example, remotely from) the electric vehicle 10 and acquires data related to the electric vehicle 10. The telematics server 30 includes a wireless communication unit 31 and a calculation unit 32.

The wireless communication unit 31 can communicate with an external computer (for example, the telematics terminal 20) in the wireless manner. In particular, the wireless communication unit 22 of the telematics terminal 20 can communicate with the wireless communication unit 31 of the telematics server 30 in the wireless manner.

The calculation unit 32 can perform computation based on data acquired via the wireless communication unit 31 and output a result.

The battery diagnosis system according to the present embodiment includes the telematics terminal 20 and the telematics server 30. In particular, the battery diagnosis system includes the data acquisition unit 21 and the calculation unit 32.

Each of the battery management device 14, the telematics terminal 20, and the telematics server 30 has a configuration as a known computer, and includes, for example, a computation unit and a storage unit. The computation unit includes, for example, a processor, and the storage unit includes, for example, a storage medium such as a semiconductor memory device and a magnetic disk device. A part or all of the storage medium may be a non-transitory storage medium.

The storage unit may store a program. By the processor executing the program, each computer may execute a function described in the present embodiment, and thus the battery diagnosis system may be implemented.

In the example in FIG. 1, each of the battery management device 14, the telematics terminal 20, and the telematics server 30 is implemented by an independent computer, but a hardware structure is not limited to that in FIG. 1, and various designs are possible as described in [Other Embodiments] to be described later.

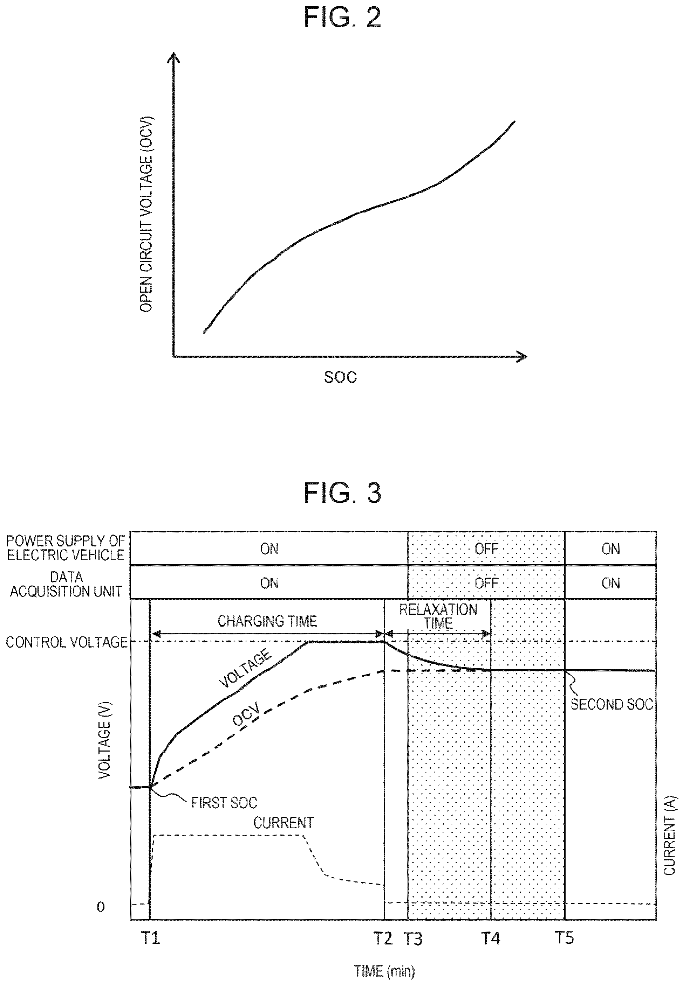

FIG. 2 shows an example of a SOC-OCV relationship table related to the battery 13. The SOC-OCV relationship table is a table for indicating a relationship between an OCV (a voltage, particularly an open circuit voltage) and a SOC (a charging rate or a charging state), and is stored in, for example, a storage unit of the calculation unit 32. The SOC of the battery 13 can be calculated based on the OCV of the battery 13 using the SOC-OCV relationship table. The storage unit may store a SOC-charging resistance curve, a SOC-discharging resistance curve, the number of battery cells, a rated capacity, and the like.

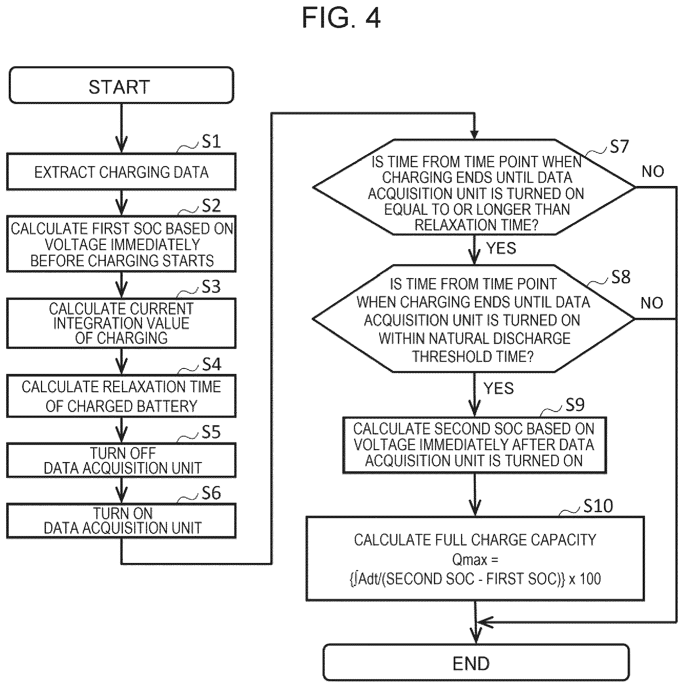

Hereinafter, an example of operations of the secondary battery state diagnosis system according to the present embodiment will be described with reference to FIGS. 3 and 4.

FIG. 3 is a diagram showing a change in a situation during charging and before and after the charging when external charging is performed on the battery 13. The external charging means, for example, charging in which power is supplied from a charging facility provided outside the electric vehicle 10. In FIG. 3, a horizontal axis represents time, a left vertical axis represents a voltage (a thick-solid-line graph and a thick-dashed-line graph), and a right vertical axis represents a current (a thin-dashed-line graph).

FIG. 4 is a flowchart showing a process executed by the secondary battery state diagnosis system. Depending on the change in the situation as shown in FIG. 3, the battery diagnosis system executes the process in FIG. 4.

The charging starts at a time point T1 (a first time point) in FIG. 3. That is, voltage application related to the charging starts. The battery 13 may not be normally charged due to a failure thereof or the like, but even in such a case, the voltage application related to the charging starts. At this time point, the power supply of the electric vehicle 10 is turned on, and a power supply (or data acquisition operations, the same applies hereinafter) of the data acquisition unit 21 of the telematics terminal 20 is also turned on.

Before the time point T1 (it may be considered that the time point T1 is substantially included), the OCV can be measured and is acquired by the data acquisition unit 21.

When the charging starts, the calculation unit 32 extracts and acquires charging data (step S1 in FIG. 4). The charging data particularly includes a voltage (a first voltage) at the time point T1. The first voltage is measured as, for example, the OCV, but a case where the first voltage is measured as a closed circuit voltage (CCV) is not particularly excluded.

Next, the calculation unit 32 calculates a first SOC based on a voltage immediately before the charging starts (step S2). Specifically, the SOC (the first SOC) at the time point T1 is calculated using the SOC-OCV relationship table based on the voltage (the first voltage) at the time point T1. Since the first voltage may not match the OCV according to a current value to be measured, the first SOC may be calculated by estimating, as the OCV, a voltage obtained by subtracting an overvoltage from the first voltage at this time. That is, the calculation unit 32 may calculate the first SOC based on a value obtained by subtracting the overvoltage from the first voltage. In this manner, estimation accuracy is improved.

After the time point T1, the voltage of the battery 13 increases as the charging proceeds. During the charging, the OCV cannot be accurately measured due to polarization of the battery 13, and as shown in FIG. 3, a difference occurs between a voltage to be measured (thick solid lines) and an original OCV (that is, a voltage when no polarization is assumed. thick dashed lines).

The charging ends at a time point T2 (a second time point). That is, the voltage application related to the charging ends. The battery 13 may not be normally charged due to a failure thereof or the like, but even in such a case, the voltage application related to the charging ends. A time from the time point T1 to the time point T2 is a charging time. Even at the time point T2, the OCV cannot be accurately measured due to the polarization of the battery 13. After the time point T2, the polarization starts to be reduced, and the voltage to be measured approaches the original OCV.

When the charging ends, the calculation unit 32 calculates a current integration value of the charging (step S3). Further, a relaxation time for polarization of the charged battery is calculated (step S4). In a secondary battery, an ion adsorption and desorption reaction occurs in an active material inside an electrode during charging and discharging. The adsorption and desorption reaction does not occur instantaneously, and it takes a certain time in the adsorption and desorption reaction. The relaxation time can be calculated based on the temperature of the battery 13, a voltage (a second voltage) at the time point T2, and the like (other data may also be used). A specific method for calculating the relaxation time can be appropriately designed by those skilled in the art based on a known technique or the like, and for example, Formula 5 described in paragraph [005] in PTL 2 can be used.

In this manner, the calculation unit 32 calculates the relaxation time of the battery 13 based on the temperature of the battery 13 and the voltage at the time point T2. The temperature used here is, for example, a temperature at the time point T2. Alternatively, a temperature at another time point may be used.

At a time point T3, the power supply of the electric vehicle 10 is turned off. Accordingly, the power supply of the data acquisition unit 21 is also turned off (step S5). Therefore, after the time point T3, the data (including a voltage) related to the battery 13 cannot be measured and acquired. The time point T3 is assumed to be before a time point when the polarization of the battery 13 is eliminated. That is, the OCV cannot be accurately measured even at the time point T3.

At a time point T4, the polarization of the battery 13 is sufficiently eliminated, and a polarization voltage is attenuated to the extent that a SOH estimation error is hardly affected. That is, a time from the time point T2 to the time point T4 can be referred to as the relaxation time for polarization of the battery 13. Since the power supply of the data acquisition unit 21 is turned off at the time point T4, the OCV cannot be measured. The time point T4 is a time point at which the voltage related to the polarization is 0. Alternatively, the time point T4 may be a time point at which the voltage related to the polarization is less than a predetermined threshold.

At a time point T5 (a third time point), the power supply of the electric vehicle 10 is turned on. Accordingly, the power supply of the data acquisition unit 21 is also turned on (step S6). Therefore, the data acquisition unit 21 acquires data (including a voltage) related to the battery 13 at the time point T5 and thereafter.

The calculation unit 32 determines whether a time from the time point (the time point T2) when the charging ends to the time point (the time point T5) when the power supply of the data acquisition unit is turned on is equal to or longer than the relaxation time (step S7). When the time from the time point T2 to the time point T5 is shorter than the relaxation time, the battery diagnosis system ends the process in FIG. 4. In this case, since a full charge capacity to be described later (step S10 to be described later) is not calculated, the calculation of the full charge capacity with low accuracy including an influence of polarization is avoided.

When the time from the time point T2 to the time point T5 is equal to or longer than the relaxation time, the calculation unit 32 determines whether the time from the time point T2 to the time point T5 is within a predetermined natural discharge time threshold (step S8). The natural discharge time threshold can be appropriately determined by those skilled in the art as a threshold of a time when natural discharge of the battery 13 is large enough to the extent that the natural discharge cannot be ignored. Specific examples can include 5 days, 7 days, and the like.

When the time from the time point T2 to the time point T5 exceeds the natural discharge time threshold, the battery diagnosis system ends the process in FIG. 4. In this case, since the full charge capacity to be described later (step S10 to be described later) is not calculated, the calculation of the full charge capacity with low accuracy including an influence of natural discharge is avoided.

When the time from the time point T2 to the time point T5 is within the natural discharge time threshold, the calculation unit 32 calculates a SOC (a second SOC) at the time point T5 using the SOC-OCV relationship table based on a voltage at the time point T5 (more precisely, a voltage immediately after the power supply of the data acquisition unit 21 is turned on) (a third voltage) (step S9). Since the third voltage may not match the OCV according to a current value to be measured, the second SOC may be calculated by estimating, as the OCV, a voltage obtained by subtracting an overvoltage from the third voltage at this time. That is, the calculation unit 32 may calculate the second SOC based on a value obtained by subtracting the overvoltage from the third voltage. In this manner, the estimation accuracy is improved.

Next, the calculation unit 32 estimates the full charge capacity of the battery 13 based on a current related to the charging (a current measured during the charging time), the SOC (the first SOC) at the time point T1, and the SOC (the second SOC) at the time point T5 (step S10).

The full charge capacity can be estimated using, for example, the following formula.

$$\mathrm{Qmax} = \{\textstyle\int \mathrm{Adt}/(\text{second SOC} - \text{first SOC})\} \times 100$$

where Qmax is the full charge capacity, A is a current value measured during the charging time, and an integration is performed on the charging time (from the time point T1 to the time point T2). According to this formula, the full charge capacity is calculated based on a ratio of an increment of SOC changed by the charging to the quantity of electricity corresponding to the increment. The full charge capacity is not limited to the above formula, and may be estimated by another method.

After step S10, the battery diagnosis system ends the process in FIG. 4. Although not particularly shown in FIG. 4, the battery diagnosis system may store or output the estimated full charge capacity.

As described above, according to the battery diagnosis system of Embodiment 1, it is possible to estimate the full charge capacity more accurately based on the first SOC and the second SOC even when there is a period in which data on the battery 13 is not acquired.

[Embodiment 2]

Hereinafter, a secondary battery state diagnosis system according to Embodiment 2 will be described. In Embodiment 2, operations of the calculation unit 32 in Embodiment 1 are partially changed. Hereinafter, description of parts common to Embodiment 1 may be omitted.

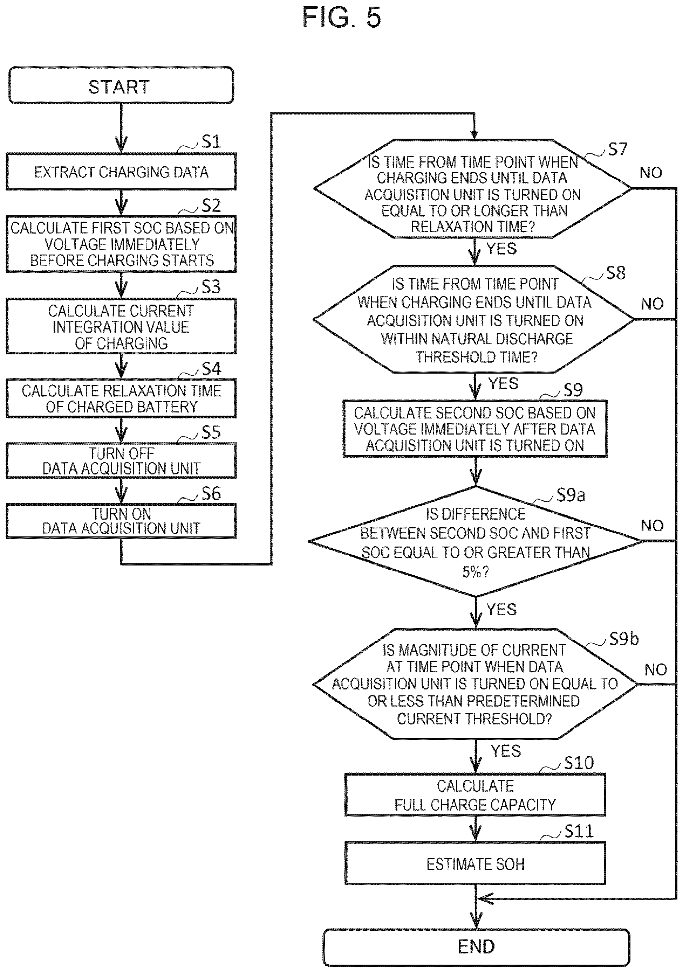

FIG. 5 is a flowchart showing a process executed by the secondary battery state diagnosis system according to Embodiment 2. Steps S1 to S9 can be the same as those in Embodiment 1.

After step S9, the calculation unit 32 determines whether a difference between the second SOC and the first SOC is equal to or greater than a predetermined difference threshold (step S9a). As a specific example, the predetermined difference threshold is 5%. In this specific example, when the first SOC is 50% and the second SOC is 53%, a difference is 3%, and therefore it is determined that the difference is less than the threshold. Alternatively, when the first SOC is 50% and the second SOC is 56%, a difference is 6%, and therefore it is determined that the difference is equal to or greater than the threshold.

When the difference between the second SOC and the first SOC is less than the threshold, the battery diagnosis system ends the process in FIG. 4. That is, the calculation unit 32 does not calculate the full charge capacity.

When the difference between the second SOC and the first SOC is equal to or greater than the threshold, the calculation unit 32 determines whether magnitude of a current acquired by the data acquisition unit 21 at the time point (the time point T5) when the data acquisition unit is turned on is equal to or less than a predetermined current threshold (step S9b).

When the magnitude of the current exceeds the predetermined current threshold, the battery diagnosis system ends the process in FIG. 4. That is, the calculation unit 32 does not calculate the full charge capacity.

When the magnitude of the current is equal to or less than the predetermined current threshold, the calculation unit 32 calculates the full charge capacity of the battery 13 as in Embodiment 1 (step S10).

Further, the calculation unit 32 estimates a state of health (SOH) of the battery 13 based on the full charge capacity of the battery 13 (step S11). The SOH is estimated as, for example, a value obtained by dividing a predetermined capacity (as a specific example, an initial full charge capacity) by the full charge capacity.

As described above, according to the battery diagnosis system of Embodiment 2, as in Embodiment 1, it is possible to estimate the full charge capacity more accurately based on the first SOC and the second SOC even when there is a period in which data on the battery 13 is not acquired.

Further, in Embodiment 2, the full charge capacity is estimated only when the difference between the second SOC and the first SOC is equal to or greater than 5% based on the determination in step S9a, and is not estimated otherwise. Therefore, the estimation is performed only when the SOC greatly changes and the estimation of the full charge capacity is necessary again, and the process is made efficient. By setting the threshold as being equal to or greater than 5%, it is possible to appropriately determine whether to reestimate the full charge capacity. The threshold is more preferably 10% or more.

In Embodiment 2, the full charge capacity is estimated only when a large current does not flow at the time point T5 (that is, when large charging or discharging is not performed) based on the determination in step S9b, and is not estimated otherwise. Here, when a large current flows, estimation accuracy of the full charge capacity may be reduced due to polarization of the battery 13 or the like, but in such a case, the estimation of the full charge capacity is omitted based on the determination in step S9b, and the calculation of the full charge capacity with low accuracy is avoided.

Further, in Embodiment 2, since the SOH is estimated based on the full charge capacity, it is possible to know the state of health or a deterioration state of the battery 13. For example, the SOH can be estimated based on a relationship in SOH = 100 $\times$ full charge capacity of battery/rated capacity of battery.

[Other Embodiments]

In Embodiments 1 and 2, determination processing in steps S8, S9a, and S9b can be performed in any combination. For example, step S8 may be omitted in Embodiment 1, and the full charge capacity may be estimated regardless of a natural discharge situation.

A hardware structure of the secondary battery state diagnosis system is not limited to that in FIG. 1, and various modifications are possible. For example, the calculation unit 32 may be provided in the telematics terminal 20 (in this case, the telematics server 30 may be omitted). The data acquisition unit 21 and the calculation unit 32 may be provided in the battery management device 14 (in this case, the telematics terminal 20 and the telematics server 30 may be omitted). In addition, the data acquisition unit 21 may be provided in the telematics server 30 (in this case, the telematics terminal 20 may have only a relay function of data transmission and reception).

Reference Signs List

10: electric vehicle
11: motor
11: electric vehicle
12: inverter
13: battery
14: battery management device
15: ignition switch
20: telematics terminal (battery diagnosis system)
21: data acquisition unit
22: wireless communication unit
30: telematics server (battery diagnosis system)
31: wireless communication unit
32: calculation unit
T1: first time point
T2: second time point
T5: third time point

All publications, patents, and patent applications cited in the present specification are incorporated into the present specification by citation.

## Claims

1. A secondary battery state diagnosis system comprising:

   a data acquisition unit; and
   a calculation unit, wherein
   the data acquisition unit acquires a current, a voltage, and a temperature related to a battery cell or a battery pack obtained by combining a plurality of battery cells,
   the calculation unit

   a) calculates a first SOC using a SOC-OCV relationship table based on a first voltage at a first time point when voltage application related to charging starts in a case where external charging is performed on the battery cell or the battery pack, the SOC-OCV relationship table being a table for indicating a relationship between the voltage and the SOC,
   b) calculates, when the voltage application related to the charging ends at a second time point, a relaxation time of the battery cell or the battery pack based on a second voltage at the second time point and the temperature,
   c) calculates, when the data acquisition unit acquires a third voltage at a third time point after the second time point, a second SOC using the SOC-OCV relationship table based on the third voltage, and
   d) estimates, when a time from the second time point to the third time point is equal to or longer than the relaxation time, a full charge capacity of the battery cell or the battery pack based on the current related to the charging, the first SOC, and the second SOC.

2. The secondary battery state diagnosis system according to claim 1, wherein
   the calculation unit estimates the full charge capacity when a difference between the second SOC and the first SOC is equal to or greater than a predetermined difference threshold.

3. The secondary battery state diagnosis system according to claim 1, wherein
   the calculation unit calculates the first SOC based on a value obtained by subtracting an overvoltage from the first voltage, and/or calculates the second SOC based on a value obtained by subtracting an overvoltage from the third voltage.

4. The secondary battery state diagnosis system according to claim 1, wherein
the calculation unit estimates the full charge capacity when magnitude of a current acquired by the data acquisition unit at the third time point is equal to or less than a predetermined current threshold.

5. The secondary battery state diagnosis system according to claim 1, wherein
the calculation unit further estimates a SOH of the battery cell or the battery pack based on the full charge capacity.

6. A secondary battery state diagnosis method comprising:

a data acquisition unit acquiring a current, a voltage, and a temperature related to a battery cell or a battery pack obtained by combining a plurality of battery cells; and
the calculation unit

a) calculating a first SOC using a SOC-OCV relationship table based on a first voltage at a first time point when voltage application related to charging starts in a case where external charging is performed on the battery cell or the battery pack, the SOC-OCV relationship table being a table for indicating a relationship between the voltage and the SOC,
b) calculating, when the voltage application related to the charging ends at a second time point, a relaxation time of the battery cell or the battery pack based on a second voltage at the second time point and the temperature,
c) calculating, when the data acquisition unit acquires a third voltage at a third time point after the second time point, a second SOC using the SOC-OCV relationship table based on the third voltage, and
d) estimating, when a time from the second time point to the third time point is equal to or longer than the relaxation time, a full charge capacity of the battery cell or the battery pack based on the current related to the charging, the first SOC, and the second SOC.

7. The secondary battery state diagnosis method according to claim 6, wherein
the calculation unit estimates the full charge capacity when a difference between the second SOC and the first SOC is equal to or greater than a predetermined difference threshold.

8. The secondary battery state diagnosis method according to claim 6, wherein
the calculation unit calculates the first SOC based on a value obtained by subtracting an overvoltage from the first voltage, and/or calculates the second SOC based on a value obtained by subtracting an overvoltage from the third voltage.

9. The secondary battery state diagnosis method according to claim 6, wherein
the calculation unit estimates the full charge capacity when magnitude of a current acquired by the data acquisition unit at the third time point is equal to or less than a predetermined current threshold.

10. The secondary battery state diagnosis method according to claim 6, wherein
the calculation unit further estimates a SOH of the battery cell or the battery pack based on the full charge capacity.

# FIG. 1

# FIG. 2

# FIG. 3

# FIG. 4

```
        START
          │
          ▼
    EXTRACT CHARGING DATA                          ~S1
          │
          ▼
  CALCULATE FIRST SOC BASED ON                     ~S2
       VOLTAGE IMMEDIATELY
     BEFORE CHARGING STARTS
          │
          ▼
     CALCULATE CURRENT                             ~S3
      INTEGRATION VALUE
        OF CHARGING
          │
          ▼
  CALCULATE RELAXATION TIME                        ~S4
    OF CHARGED BATTERY
          │
          ▼
        TURN OFF                                   ~S5
   DATA ACQUISITION UNIT
          │
          ▼
        TURN ON                                    ~S6
   DATA ACQUISITION UNIT
```

IS TIME FROM TIME POINT WHEN CHARGING ENDS UNTIL DATA ACQUISITION UNIT IS TURNED ON EQUAL TO OR LONGER THAN RELAXATION TIME? — ~S7 — NO

YES

IS TIME FROM TIME POINT WHEN CHARGING ENDS UNTIL DATA ACQUISITION UNIT IS TURNED ON WITHIN NATURAL DISCHARGE THRESHOLD TIME? — ~S8 — NO

YES

CALCULATE SECOND SOC BASED ON VOLTAGE IMMEDIATELY AFTER DATA ACQUISITION UNIT IS TURNED ON — ~S9

CALCULATE FULL CHARGE CAPACITY — ~S10
$$Q_{max} = \{\int A dt / (\text{SECOND SOC} - \text{FIRST SOC})\} \times 100$$

END

# FIG. 5

START

EXTRACT CHARGING DATA ~S1

CALCULATE FIRST SOC BASED ON VOLTAGE IMMEDIATELY BEFORE CHARGING STARTS ~S2

CALCULATE CURRENT INTEGRATION VALUE OF CHARGING ~S3

CALCULATE RELAXATION TIME OF CHARGED BATTERY ~S4

TURN OFF DATA ACQUISITION UNIT ~S5

TURN ON DATA ACQUISITION UNIT ~S6

IS TIME FROM TIME POINT WHEN CHARGING ENDS UNTIL DATA ACQUISITION UNIT IS TURNED ON EQUAL TO OR LONGER THAN RELAXATION TIME? ~S7 — NO

YES

IS TIME FROM TIME POINT WHEN CHARGING ENDS UNTIL DATA ACQUISITION UNIT IS TURNED ON WITHIN NATURAL DISCHARGE THRESHOLD TIME? ~S8 — NO

YES

CALCULATE SECOND SOC BASED ON VOLTAGE IMMEDIATELY AFTER DATA ACQUISITION UNIT IS TURNED ON ~S9

IS DIFFERENCE BETWEEN SECOND SOC AND FIRST SOC EQUAL TO OR GREATER THAN 5%? ~S9a — NO

YES

IS MAGNITUDE OF CURRENT AT TIME POINT WHEN DATA ACQUISITION UNIT IS TURNED ON EQUAL TO OR LESS THAN PREDETERMINED CURRENT THRESHOLD? ~S9b — NO

YES

CALCULATE FULL CHARGE CAPACITY ~S10

ESTIMATE SOH ~S11

END

# INTERNATIONAL SEARCH REPORT

| International application No. |
| --- |
| **PCT/JP2023/038246** |

| A. | CLASSIFICATION OF SUBJECT MATTER |
| --- | --- |

*G01R 31/387*(2019.01)i; *G01R 31/382*(2019.01)i; *G01R 31/385*(2019.01)i; *G01R 31/392*(2019.01)i; *H01M 10/48*(2006.01)i; *H02J 7/00*(2006.01)i; *H02J 7/02*(2016.01)i
FI: G01R31/387; G01R31/385; G01R31/382; G01R31/392; H02J7/00 X; H02J7/02 V; H01M10/48 P; H01M10/48 301

According to International Patent Classification (IPC) or to both national classification and IPC

| B. | FIELDS SEARCHED |
| --- | --- |

Minimum documentation searched (classification system followed by classification symbols)

G01R31/387; G01R31/382; G01R31/385; G01R31/392; H01M10/48; H02J7/00; H02J7/02

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| Y | JP 2014-181924 A (KABUSHIKI KAISHA TOYOTA JIDOSHOKKI) 29 September 2014 (2014-09-29)<br>paragraphs [0002]-[0050], fig. 1-12 | 1-10 |
| Y | JP 2017-107763 A (HITACHI AUTOMOTIVE SYSTEMS, LTD.) 15 June 2017 (2017-06-15)<br>paragraph [0050] | 1-10 |
| Y | JP 2012-58028 A (CALSONIC KANSEI CORPORATION) 22 March 2012 (2012-03-22)<br>paragraph [0010] | 3, 8 |

☐ Further documents are listed in the continuation of Box C.   ☑ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
| --- | --- |
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **08 December 2023** | **26 December 2023** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
**Information on patent family members**

International application No.

**PCT/JP2023/038246**

| Patent document cited in search report | | | Publication date (day/month/year) | Patent family member(s) | | | Publication date (day/month/year) |
|---|---|---|---|---|---|---|---|
| JP | 2014-181924 | A | 29 September 2014 | WO 2014/147899 A1 paragraphs [0002]-[0052], fig. 1-12 | | | |
| JP | 2017-107763 | A | 15 June 2017 | US 2018/0375176 A1 paragraph [0079] WO 2017/099003 A1 EP 3389132 A1 CN 108370073 A | | | |
| JP | 2012-58028 | A | 22 March 2012 | (Family: none) | | | |

Form PCT/ISA/210 (patent family annex) (January 2015)

14

**EP 4 682 559 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2015202010 A
- JP 2017107763 A
- JP 2023039533 A